# EUROPEAN PATENT APPLICATION

(11) **EP 4 712 107 A1**
(43) Date of publication of application: **18.03.2026**
(21) Application number: 24803672.5
(22) Date of filing: 07.05.2024
(51) Int. Cl.: H01B 12/06, H01B 13/00, C23C 14/02, C23C 14/34, C23C 14/06

(54) **APPARATUS FOR MANUFACTURING SUPERCONDUCTING WIRES**

(30) Priority: 09.05.2023 KR 20230059545
(71) Applicant: Maru L&C Co., Ltd., Daegu 42702 (KR)
(72) Inventor: KIM, Dongjin, Daegu 42702 (KR)
(74) Representative: Potter Clarkson
(86) International application number: PCT/KR2024/006078
(87) International publication number: WO 2024/232619

(57) **Abstract**

The present disclosure relates to an apparatus for manufacturing superconducting wires, and more particularly, to an apparatus for manufacturing superconducting wires capable of reinforcing an adhesion between a substrate and a buffer layer by performing a predetermined pretreatment process before the buffer layer is deposited on the substrate.

## Description

### [Technical Field]

The present disclosure relates to an apparatus for manufacturing superconducting wires, and more particularly, to an apparatus for manufacturing superconducting wires capable of reinforcing an adhesion between a substrate and a buffer layer by performing a predetermined pretreatment process before the buffer layer is deposited on the substrate.

### [Background Art]

Superconductors can flow a large amount of current because their electrical resistance disappears at a critical temperature. Recently, research on second-generation high-temperature superconductors (coated conductors) that form a superconducting film on a thin buffer layer or a metal substrate with a biaxially oriented aggregate structure has been actively conducted.

The second-generation high-temperature superconductors may be applied to various fields. For example, wires using the second-generation high-temperature superconductors have a current transport capacity per unit area that is much superior to that of general metal wires. The wires using the second-generation high-temperature superconductors may reduce power loss in power devices and may be used in fields such as MRI, superconducting magnetic levitation trains, and superconducting propulsion ships.

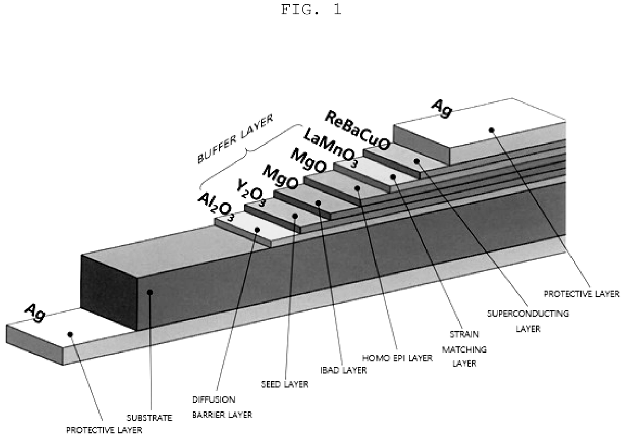

FIG. 1 is a diagram corresponding to an example of superconducting wires. As illustrated, the superconducting wires have a metal substrate, a buffer layer formed on the substrate, a superconducting layer formed on the buffer layer, and a protective layer formed on the superconducting layer.

However, when a multilayer film is deposited in this manner, the superconducting wires are repeatedly exposed to a temperature of 500 to 1000°C. There is a problem that a peeling phenomenon may occur between the metal substrate and the buffer layer due to the accumulated stress during this process.

### [Disclosure]

### [Technical Problem]

An object of the present disclosure provides an apparatus for manufacturing superconducting wires capable of reinforcing an adhesion between a substrate and a buffer layer by performing a predetermined pretreatment process before the buffer layer is deposited on the substrate.

### [Technical Solution]

In one general aspect, an apparatus for manufacturing superconducting wires includes: an unwinder that unwinds a substrate; a plurality of deposition modules that sequentially deposits a buffer layer and a superconducting layer on the substrate that is unwound and transported from the unwinder; an winder that winds the substrate on which the buffer layer and the superconducting layer passes through the deposition modules and then is deposited; and a pretreatment module disposed before the plurality of deposition modules for performing a predetermined pretreatment process on the substrate before the buffer layer is deposited on the substrate, in which the pretreatment module is configured to perform a pretreatment process for reinforcing an adhesion between the substrate and the buffer layer.

The pretreatment module may form an adhesive layer on the substrate.

The pretreatment module may include a deposition device and deposit the adhesive layer on the substrate through the deposition device, and the deposition device may be a sputtering deposition device or an electron beam deposition device.

The pretreatment module may be configured to perform plasma surface treatment on the substrate.

The pretreatment module may include a plasma generation device that generates plasma and is configured to perform the plasma surface treatment on the substrate through the plasma generated from the plasma generation device, and a reaction gas used in the plasma generation device may include at least one of Ar and O₂.

When, among the plurality of buffer layer deposition modules, a deposition module that deposits an uppermost buffer layer disposed on an uppermost portion of the buffer layer is an uppermost buffer layer deposition module, the uppermost buffer layer deposition module may be configured to perform the plasma surface treatment on the uppermost buffer layer together with the deposition of the uppermost buffer layer.

The uppermost buffer layer deposition module may include a plasma generation device that generates O₂ plasma, and is configured to perform the plasma surface treatment on the uppermost buffer layer through the O₂ plasma generated from the plasma generation device.

The pretreatment module may include a multi-turn transport device that multi-turns the substrate, and the plasma generation device may be disposed on at least one side of both side surfaces and an upper portion of the multi-turn transport device, respectively.

The uppermost buffer layer may be a lanthanum manganite layer.

Each of the plurality of deposition modules may include a multi-turn transport device that multi-turns the substrate, and the multi-turn transport devices of each of the plurality of deposition modules may have the same size and structure.

The plurality of deposition modules may be respectively arranged in a row in a left-right direction, and one of the multi-turn transport devices of each of the two adjacent deposition modules may be disposed to protrude forward compared to the other so that the substrate is transported in a straight line between the two adjacent deposition modules.

A guide roller transporting the substrate may be disposed on both sides in left-right directions of each of the plurality of deposition modules, and the substrate may be configured to be transported between the two adjacent deposition modules through the guide roller.

Each of the plurality of deposition modules may include a deposition device that deposits the buffer layer or the superconducting layer on the substrate, and a fixing plate on which the deposition device is fixedly mounted, and the fixing plate may be configured to be movable in an up-down direction.

In another general aspect, a superconducting wire manufactured by the apparatus for manufacturing superconducting wires includes: a substrate; an adhesive layer that is formed on the substrate; a buffer layer that is formed on the adhesive layer; and a superconducting layer that is formed on the buffer layer.

The adhesive layer may be a Ni layer, a Cr layer, a Ti layer, or a NiCr layer, and a thickness of the adhesive layer may be 5 to 50 nm.

### [Advantageous Effects]

According to an aspect of the present disclosure, by performing a predetermined pretreatment process before a buffer layer is deposited on a substrate, it is possible to reinforce the adhesion between a substrate and the buffer layer.

In addition, according to another aspect of the present disclosure, by configuring an apparatus in which a plurality of deposition modules having the same structure are disposed side by side, it is possible to reduce manufacturing costs and simplify a design of the equipment.

In addition, according to another aspect of the present disclosure, by performing plasma surface treatment on an uppermost buffer layer under a superconductor layer before the superconducting layer is deposited, it is possible to improve the characteristics of the superconducting wires by enhancing the crystallinity of the wires and improving the surface roughness.

### [BRIEF DESCRIPTION OF THE DRAWINGS]

FIG. 1 is a diagram corresponding to a general example of superconducting wires.
FIG. 2 is a perspective view of an apparatus for manufacturing superconducting wires according to an embodiment of the present disclosure.
FIG. 3 is a front view of FIG. 2 as viewed from the front.
FIG. 4 is a plan view of FIG. 2 viewed from the top.
FIG. 5 is a side view of FIG. 2 viewed from the side.
FIG. 6 is a cross-sectional view in a height direction of FIG. 2.
FIG. 7 is a schematic diagram of an apparatus for manufacturing superconducting wires according to an embodiment of the present disclosure.
FIG. 8 is a diagram illustrating superconducting wires manufactured by the manufacturing apparatus according to an embodiment of the present disclosure.
FIG. 9 is a diagram illustrating a multi-turn transport device according to an embodiment of the present disclosure.
FIG. 10 is a diagram schematically illustrating two adjacent deposition modules viewed from the front according to an embodiment of the present disclosure.
FIG. 11 is a diagram schematically illustrating the two adjacent deposition modules viewed from the top according to an embodiment of the present disclosure.
FIG. 12 is a diagram illustrating an example of a crystal structure of lanthanum manganite.
FIG. 13 is a schematic diagram illustrating an uppermost buffer layer deposition module according to an embodiment of the present disclosure.

### [Best Mode]

Hereinafter, the present disclosure will be described in detail with reference to the accompanying drawings.

General terms that are currently widely used are selected as terms used in the present disclosure in consideration of functions in the present disclosure but may be changed depending on the intention of those skilled in the art or a judicial precedent, the emergence of a new technique, and the like. If there is no other definition in the technical and scientific terms used, they have the meaning commonly understood by those skilled in the art in the technical field to which the present disclosure belongs

In the present disclosure and appended claims, the terms "include" or "have" means that a feature or element described in the specification is present, and unless specifically limited, it does not preclude in advance the possibility that one or more other features or components may be added.

In the present disclosure and appended claims, singular forms include plural forms unless the context clearly indicates otherwise. In addition, plural forms include singular forms unless the context clearly indicates otherwise.

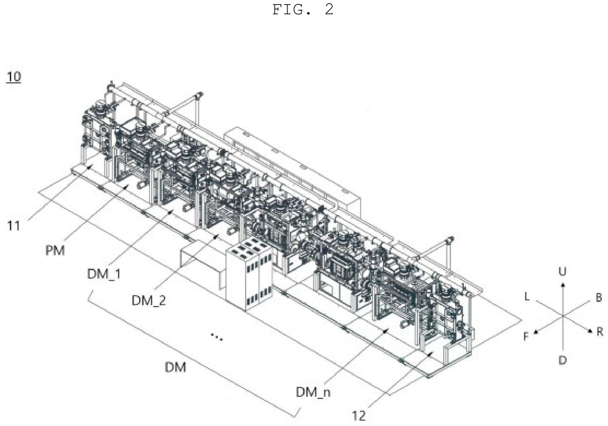

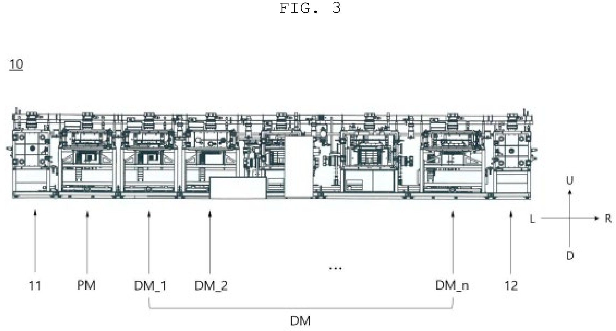

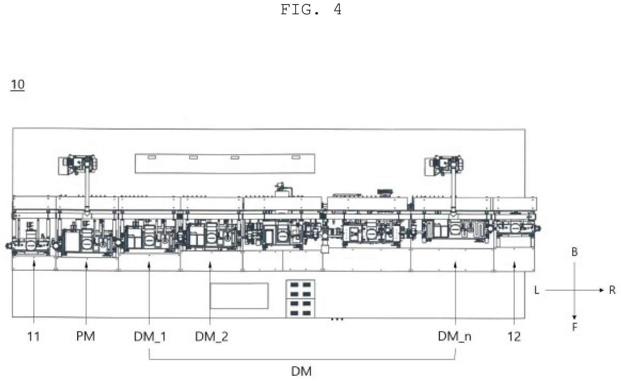

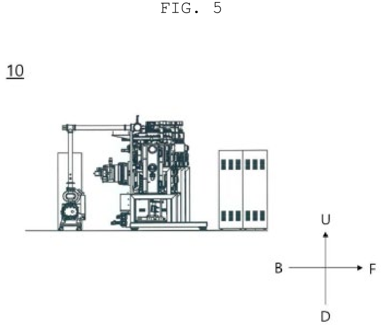

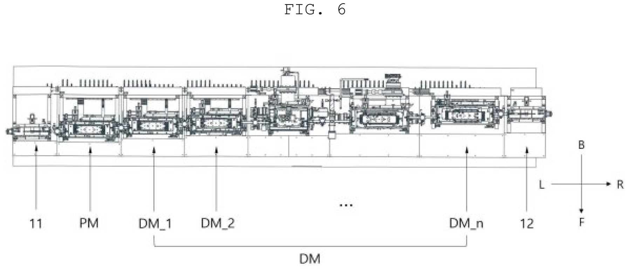

Hereinafter, symbols in the drawings may correspond to 10: Apparatus for manufacturing superconducting wires, 11: Unwinder, 12: Winder, PM: Pretreatment module, PM_d: Deposition device, PM_p: Plasma generation device, DM: Deposition module, DM_b: Buffer layer deposition module, DM_s: Superconducting layer deposition module, 100: Multi-turn transport device, 200: Deposition device, 300: Fixing plate, 400: Plasma generation device, 20: Superconductor wire, and 21: Substrate, respectively. FIG. 2 is a perspective view of an apparatus for manufacturing superconducting wires according to an embodiment of the present disclosure, FIG. 3 is a front view of FIG. 2 as viewed from the front, FIG. 4 is a plan view of FIG. 2 viewed from the top, FIG. 5 is a side view of FIG. 2 viewed from the side, and FIG. 6 is a cross-sectional view in a height direction of FIG. 2. In the direction indicators of the drawings, F, B, L, R, U, and D represent front, back, left, right, up, and down, respectively.

The apparatus for manufacturing superconducting wires according to an embodiment of the present disclosure includes an unwinder that unwinds a substrate, a plurality of deposition modules that sequentially deposits a buffer layer and a superconducting layer on a substrate that is unwound and transported from the unwinder, and a winder that winds the substrate on which the buffer layer and the superconducting layer passes through the deposition modules and then is deposited, and further includes a pretreatment module disposed before the plurality of deposition modules for performing a predetermined pretreatment process on the substrate before the buffer layer is deposited on the substrate. In addition, the pretreatment module is configured to perform a pretreatment process for reinforcing an adhesion between the substrate and the buffer layer.

Referring to FIG. 2, an apparatus 10 for manufacturing superconducting wires largely includes an unwinder 11 for unwinding a substrate, a plurality of deposition modules DM, and a winder 12 for winding the substrate on which the buffer layer and the superconducting layer are formed, that is, for winding superconducting wires.

The unwinder 11 may be a roller that unwinds a substrate provided in a roll form, and the winder 12 may be a roller that winds a substrate, i.e., superconducting wires, on which deposition is completed, in a roll form after passing through the plurality of deposition modules DM.

The plurality of deposition modules DM sequentially deposit the buffer layer and the superconducting layer on the substrate unwound and transported from the unwinder 11. The plurality of deposition modules DM may be arranged sequentially to sequentially deposit buffer layers by type on the substrate, and may deposit a superconducting layer on an uppermost buffer layer of the substrate on which the buffer layer has been deposited.

The number and arrangement order of the deposition modules DM may be adjusted in response to the type and order of the buffer layer and superconducting layer. For example, describing a case of depositing the buffer layer and the superconducting layer with a structure such as FIG. 1, a first buffer layer, an Al₂O₃ diffusion barrier layer, a Y₂O₃ seed layer that is a second buffer layer, an MgO IBAD layer that is a third buffer layer, a fourth buffer layer, an MgO Homo Epi layer, and a fifth buffer layer, a LaMnO₃ strain matching layer, are sequentially stacked and formed on the substrate, and a ReBaCuO superconducting layer is formed on the strain matching layer which is the fifth buffer layer. To this end, the apparatus 10 according to the present disclosure may be configured to include five buffer layer deposition modules DM_1, DM_2, ..., and DM_5 and one superconducting layer deposition module DM_n.

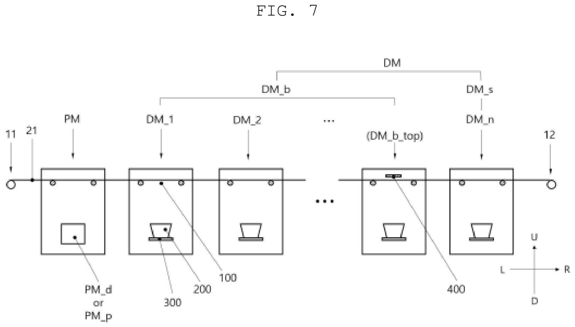

FIG. 7 is a schematic diagram of the apparatus for manufacturing superconducting wires according to an embodiment of the present disclosure, and additional description will be made with reference thereto. Among the plurality of deposition modules DM, the five buffer layer deposition modules including DM_1, DM_2, ..., and DM_5 may be represented as DM_b, and one superconducting layer deposition module DM_n may be represented as DM_s.

Meanwhile, although not illustrated separately, the plurality of deposition modules DM may further include a protective layer deposition module for forming a protective layer on one surface and the other surface of the superconducting wire, that is, on surfaces of the substrate and the superconducting layer.

The apparatus according to the present disclosure further includes a pretreatment module PM disposed before the plurality of deposition modules DM. As illustrated in FIGS. 2 and 7, the pretreatment module PM is disposed before the deposition module DM and performs a predetermined pretreatment process on the substrate before the buffer layer is deposited on the substrate, specifically, before the first buffer layer is deposited.

The pretreatment process is a process for reinforcing the adhesion between the substrate and the buffer layer, particularly, the adhesion between the first buffer layer, and since the apparatus according to the present disclosure is configured to perform the pretreatment process by having the pretreatment module PM, the adhesion between a metal substrate and the buffer layer is reinforced, thereby eliminating a peeling phenomenon between the substrate and the buffer layer due to heating as described above.

More specifically, the pretreatment module may form an adhesive layer on the substrate, that is, between the substrate and the first buffer layer. Alternatively, the pretreatment module may perform plasma surface treatment on the substrate.

First, an example where the pretreatment module forms an adhesive layer between the substrate and the first buffer layer will be described.

Referring to FIG. 7, the pretreatment module PM may include a deposition device PM_d, and may deposit an adhesive layer on the substrate through the deposition device PM_d. The deposition device PM_d may be configured as a sputtering deposition device or an electron beam deposition device, and may also include a thermal deposition device or a pulsed laser deposition device.

The sputtering deposition device may be a device that accelerates plasma through ionized gas at a low vacuum to collide with a target and eject atoms to form a thin film on the substrate, and the electron beam deposition device may correspond to a device that mounts the substrate on which a thin film of a metal or ceramic material is to be deposited inside a vacuum chamber that maintains a high vacuum, and then evaporates a target from a source formed as a target to be deposited on the substrate and deposits the target on the substrate.

In addition, according to another aspect of the present disclosure, the superconducting wires manufactured by an apparatus in which the pretreatment module forms an adhesive layer on the substrate include: the substrate; the adhesive layer formed on the substrate; the buffer layer formed on the adhesive layer; and the superconducting layer formed on the buffer layer.

In this case, the adhesive layer is composed of a Ni layer, a Cr layer, a Ti layer, or a NiCr layer, and a thickness of the adhesive layer may be composed of 5 nm or more and 50 nm or less at the same time or separately.

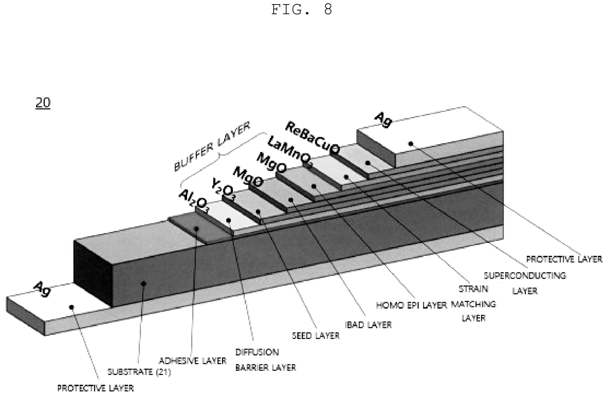

As an example, FIG. 8 is a diagram illustrating the configuration of superconducting wires manufactured from the apparatus in which the pretreatment module forms the adhesive layer, and as illustrated, the superconducting wires of the present disclosure may further form the adhesive layer between the substrate and an Al₂O₃ diffusion prevention layer that is the first buffer layer.

In the following, as another embodiment, the case in which the pretreatment module is configured to perform plasma surface treatment on the substrate will be described.

Referring back to FIG. 7, the pretreatment module PM may include a plasma generation device PM_p that generates plasma, and the substrate may be subjected to the plasma surface treatment through the plasma generated from the plasma generation device PM_p.

The plasma generation device may correspond to a device that uses an electromagnetic field to dissociate a reaction gas to generate plasma including free electrons, cations, neutral atoms, neutral molecules, etc.

In this case, the reaction gas used in the plasma generation device PM_p may include at least one of Ar and O₂. When Ar is included as the reaction gas, impurities on the wire surface may be removed (cleaned) by Ar bombardment, and the surface roughness of the substrate may be improved, thereby increasing a bonding area and increasing the adhesion between the substrate and the first buffer layer. In addition, when O₂ is included as the reaction gas, organic substances on the substrate surface are removed (ashed) by the O₂ reaction, and wettability is improved through surface oxidation of the substrate, thereby improving the adhesion between the substrate and the first buffer layer. According to the present disclosure, based on this principle, as the reaction gas, Ar may be used, O₂ may be used, or a mixture of Ar and O₂ may be used simultaneously.

Hereinafter, the overall structure of the apparatus 10 for manufacturing superconducting wires according to the present disclosure will be described as an example.

Referring back to FIGS. 2 to 7, the plurality of deposition modules DM may be arranged sequentially, respectively.

Each of the plurality of deposition modules DM for depositing the buffer layer and the superconducting layer may include a transport device 100 for multi-turning the substrate or wire (the substrate on which at least one buffer layer is formed, hereinafter referred to as the substrate).

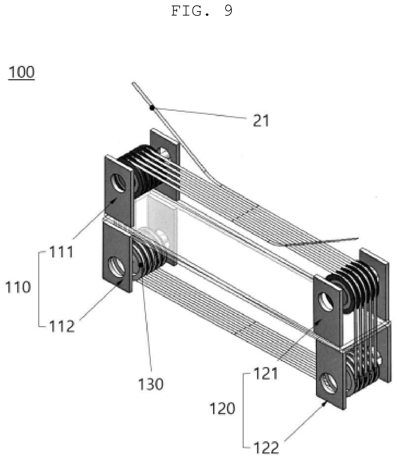

FIG. 9 is a diagram illustrating a multi-turn transport device according to an embodiment of the present disclosure. The multi-turn transport device 100 of the present disclosure includes a first reel part 110 and a second reel part 120 spaced apart in a left-right direction, and the first reel part 110 and the second reel part 120 include upper rolls 111 and 121 and lower rolls 112 and 122, respectively, and the upper rolls 111 and 121 and the lower rolls 112 and 122 of the first reel part 110 and the second reel part 120 are each configured with a structure in which a plurality of rollers 130 are installed, and may correspond to a multi-turn reel-to-reel device configured to allow the substrate to be multi-turned between the first reel part 110 and the second reel part 120.

In this case, in an embodiment, the device 10 may be configured such that the multi-turn transport devices 100 of each of the plurality of deposition modules DM has the same size and structure. In this way, since the multi-turn transport device 100 of each deposition module DM is configured identically, the manufacturing cost of the entire device may be reduced and the design of the equipment may be simplified.

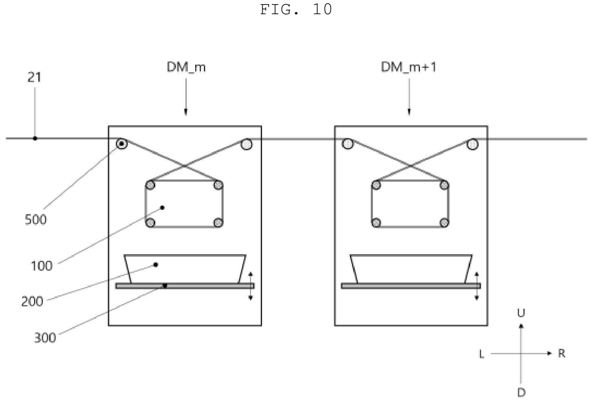

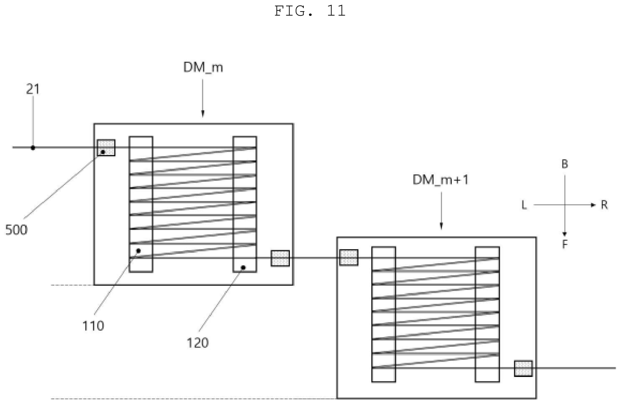

FIG. 10 is a diagram schematically illustrating two adjacent deposition modules viewed from the front according to an embodiment of the present disclosure and FIG. 11 is a diagram schematically illustrating the two adjacent deposition modules viewed from the top according to an embodiment of the present disclosure. Two adjacent deposition modules DM_m and DM_m+1 may be disposed to be spaced apart from each other, or, although not illustrated, may be disposed to be in close contact with each other, and the substrate or wire may be configured not to be exposed to the outside between a connection portions of the two deposition modules DM_m and DM_m+1.

In an embodiment, the plurality of deposition modules including the multi-turn transport device are arranged in a row in the left-right direction, and one of the multi-turn transport devices of each of the two adjacent deposition modules is arranged to protrude forward compared to the other, so that the substrate or wire may be transported in a straight line between the two adjacent deposition modules.

First, referring to FIG. 11, one of the multi-turn transport devices 100 of each of the two adjacent deposition modules DM_m and DM_m+1 may be disposed to protrude forward compared to the other. This is to align a transport direction of the substrate coming out of the multi-turn transport device 100 of one deposition module DM and a transport direction of the substrate entering the multi-turn transport device 100 of the adjacent deposition module DM. The two adjacent deposition modules DM_m and DM_m+1 may be disposed to be misaligned in a front-back direction, so the substrate may be transported in a straight line between the two adjacent deposition modules DM_m and DM _m+1. This may prevent the substrate from being damaged by being twisted or bent during the transport process.

Meanwhile, FIG. 11 highlights the disposition structure of the two adjacent deposition modules DM_m and DM_m+1, and a more realistic example may be confirmed through FIG. 6 corresponding to the cross-sectional view in the height direction of FIG. 2. In addition, when a plurality of deposition modules DM are sequentially referred to as first, second, and third deposition modules, the deposition modules may be disposed so as to be retracted or protruded in a parallel manner, such that the first deposition module protrudes forward more than the second deposition module, and the second deposition module protrudes forward more than the third deposition module, or the plurality of deposition modules may be disposed in a zigzag manner such that the first deposition module protrudes forward more than the second deposition module and the third deposition module protrudes forward more than the second deposition module, and by combining the disposition relationships of these two manners, some of the plurality of modules may be retracted or protruded in the parallel manner and the rest may be arranged in the zigzag manner.

In addition, in an embodiment, the plurality of deposition modules including the multi-turn transport device may be configured such that guide rollers for transporting the substrate are disposed on both sides of each of the deposition modules in the left-right direction, and the substrate is transported between two adjacent deposition modules through the guide rollers.

As illustrated in FIGS. 10 and 11, guide rollers 500 are respectively disposed on both sides of each deposition module DM in the left-right direction, that is, on one side and the other side of the multi-turn transport device 100 of the deposition module DM in the left-right direction, and the substrate may be transported between the two adjacent deposition modules DM_m and DM_m+1 through the guide rollers 500. In this case, the guide rollers 500 may be configured to adjust the transport direction or angle of the substrate, thereby helping to transport the substrate in a straight line.

Referring to FIG. 10, each deposition module DM of the manufacturing device according to the present disclosure may include a deposition device 200 for depositing the buffer layer or the superconducting layer on the substrate. The deposition device 200 may be disposed below the substrate that is multi-turned by the multi-turn transport device. The deposition device 200 may be configured as a sputtering deposition device or an electron beam deposition device, such as the deposition device PM_d of the above-described pretreatment module, and may be appropriately selected in response to the type of the buffer layer or the type of the superconducting layer.

In an embodiment, each deposition module DM includes a fixing plate 300 on which the deposition device 200 of the corresponding deposition module DM is mounted and fixed. In this case, the fixing plate 300 may be configured to be movable in an up-down direction. The fixing plate 300 may be moved manually or automatically. To this end, a device such as an actuator may be additionally provided.

As the fixing plate 300 is configured to move in the up-down direction in this way, the deposition amount may be controlled by adjusting the distance between the substrate and the deposition device 200, and also, when a certain work needs to be performed on the deposition device 200, such as replacing the deposition device 200 or cleaning the deposition plate, the fixing plate 300 may be used to move the deposition device 200 downward, so that work may be done in a wider space, thereby improving accessibility and work convenience.

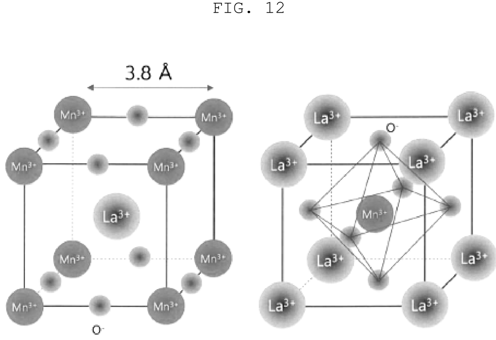

Meanwhile, referring back to the superconducting wires corresponding to one example of FIG. 1, a LaMnO₃ i.e., a lanthanum manganite (LMO) strain-matching layer, may be formed as the fifth buffer layer on the uppermost portion of the buffer layer. FIG. 12 is a diagram illustrating a crystal structure of lanthanum manganite. The superconducting layer may be formed on this lanthanum manganite strain matching layer. In this case, the superconducting layer may be sputtering deposited. However, the sputtering is a method of depositing a thin film on the substrate or wire by colliding Ar+ ions with a target to eject molecules. In this process, the thin film may be formed in the form of LaMnOₓ in which intramolecular oxygen O⁻ is separated by strong energy. To supplement this, oxygen O₂ gas may be added together with Ar gas to induce a thin film to be formed as normal LMO molecules through the combination of the ejected LMOₓ and oxygen. Nevertheless, the LMO thin film formed on the wire may lack some oxygen, resulting in the existence of oxygen vacancies. Ultimately, a LMO thin film with a different composition ratio may be formed locally, and may cause a change in the formed lanthanum manganite buffer layer over time, thereby lowering the crystallinity of the superconducting layer and causing the deterioration in performance of the manufactured superconducting wires.

On the other hand, the device 10 according to the present disclosure proposes the following configuration to solve this problem.

In an embodiment, the device 10 may be configured such that the uppermost buffer layer deposition module for depositing the uppermost buffer layer may be configured to perform the plasma surface treatment on the uppermost buffer layer together with the deposition of the uppermost buffer layer. In addition, the uppermost buffer layer deposition module includes the plasma generation device that generates O₂ plasma, and is configured to perform the plasma surface treatment on the uppermost buffer layer through the O₂ plasma generated from the plasma generation device.

In this way, the manufacturing device according to the present disclosure may help an LMO layer having an ideal composition ratio to be deposited by injecting activated oxygen ions using remote plasma together with the deposition of the uppermost buffer layer by an uppermost buffer layer deposition module DM_b_top. From this, it is possible to suppress the change of the uppermost buffer layer over time, especially the lanthanum manganite buffer layer, and minimize the deterioration in the characteristics of the superconducting wires.

The uppermost buffer layer described above means the buffer layer that is arranged on the uppermost portion of a plurality of buffer layers and has a superconducting layer formed thereon, and as described above, the uppermost buffer layer may be the lanthanum manganite layer.

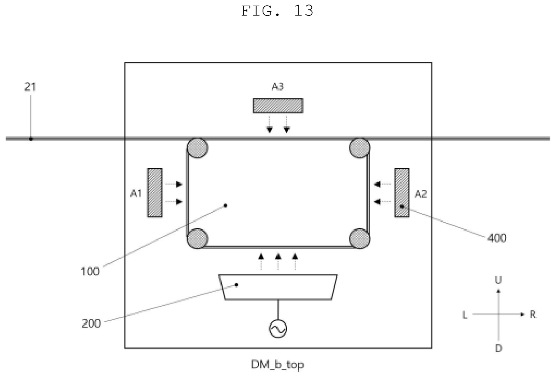

Referring to FIG. 13, which schematically illustrates the uppermost buffer layer deposition module described above, as illustrated, the uppermost buffer layer deposition module DM_b_top includes the deposition device 200 for depositing the uppermost buffer layer and a plasma generation device 400 for generating plasma, and may be configured to deposit the uppermost buffer layer through the deposition device 200 and simultaneously perform the plasma surface treatment on the uppermost buffer layer through the plasma generated from the plasma generation device 400.

In this case, the reaction gas used in the plasma generation device 400 may use O₂. That is, the uppermost buffer layer deposition module DM_b_top may be configured so that the surface of the wire on which lanthanum manganite is deposited is exposed to the corresponding O₂ plasma in the vacuum state through the O₂ plasma generation device 400.

Accordingly, LaMnOₓ and oxygen deposited on the surface of the wire react to change into a stable crystal structure of LaMnO₃, thereby improving the crystallinity of LMO and improving the surface roughness. Finally, the crystallinity of the superconducting layer thin film formed on the LMO layer, which is the uppermost buffer layer, is improved, thereby improving the characteristics of the superconducting wires.

In an embodiment, the plasma generation source of the plasma generation device 400 may be configured as an ion source or a remote plasma source (RPS). In addition, the plasma generation device 400 may be configured as one or more than two. In this case, as illustrated in FIG. 13, the plasma generation device 400 may be disposed on at least one of both side surfaces and the upper portion of the multi-turn transport device 100 described above, that is, in areas A1, A2, and A3 in the drawings.As described above, according to the present disclosure, the predetermined pretreatment process may be performed before the buffer layer is deposited on the substrate to reinforce adhesion between the substrate and the buffer layer, and the plurality of deposition modules having the same structure may be disposed side by side to configure the device, thereby reducing the manufacturing cost and simplifying the design of the equipment, and by performing the plasma surface treatment on the uppermost buffer layer under the superconducting layer before the superconducting layer is deposited, the crystallinity of the wire may be improved and the surface roughness may be improved, thereby improving the characteristics of the superconducting wires.

Although embodiments of the present disclosure have been described hereinabove with reference to the accompanying drawings, those skilled in the art to which the present disclosure pertains will be able to understand that the present disclosure may be implemented in other specific forms without departing from the spirit or essential feature of the present disclosure. Therefore, it is to be understood that embodiments described hereinabove are illustrative rather than being restrictive in all aspects.

## Claims

1. An apparatus for manufacturing superconducting wires, comprising:
an unwinder that unwinds a substrate;
a plurality of deposition modules that sequentially deposits a buffer layer and a superconducting layer on the substrate that is unwound and transported from the unwinder;
a winder that winds the substrate on which the buffer layer and the superconducting layer passes through the deposition modules and then is deposited; and
a pretreatment module disposed before the plurality of deposition modules for performing a predetermined pretreatment process on the substrate before the buffer layer is deposited on the substrate,
wherein the pretreatment module is configured to perform a pretreatment process for reinforcing an adhesion between the substrate and the buffer layer.

2. The apparatus of claim 1, wherein the pretreatment module forms an adhesive layer on the substrate.

3. The apparatus of claim 2, wherein the pretreatment module includes a deposition device and deposits the adhesive layer on the substrate through the deposition device, and
the deposition device is a sputtering deposition device or an electron beam deposition device.

4. The apparatus of claim 1, wherein the pretreatment module is configured to perform plasma surface treatment on the substrate.

5. The apparatus of claim 4, wherein the pretreatment module includes a plasma generation device that generates plasma, and is configured to perform the plasma surface treatment on the substrate through the plasma generated from the plasma generation device, and
a reaction gas used in the plasma generation device includes at least one of Ar and O₂.

6. The apparatus of claim 1, wherein when, among the plurality of buffer layer deposition modules, a deposition module that deposits an uppermost buffer layer disposed on an uppermost portion of the buffer layer is an uppermost buffer layer deposition module,
the uppermost buffer layer deposition module is configured to perform a plasma surface treatment on the uppermost buffer layer together with the deposition of the uppermost buffer layer.

7. The apparatus of claim 6, wherein the uppermost buffer layer deposition module includes a plasma generation device that generates O₂ plasma, and is configured to perform the plasma surface treatment on the uppermost buffer layer through the O₂ plasma generated from the plasma generation device.

8. The apparatus of claim 7, wherein the pretreatment module includes a multi-turn transport device that multi-turns the substrate, and
the plasma generation device is disposed on at least one side of both side surfaces and an upper portion of the multi-turn transport device, respectively.

9. The apparatus of claim 6, wherein the uppermost buffer layer is a lanthanum manganite layer.

10. The apparatus of claim 1, wherein each of the plurality of deposition modules includes a multi-turn transport device that multi-turns the substrate, and
the multi-turn transport devices of each of the plurality of deposition modules have the same size and structure.

11. The apparatus of claim 10, wherein the plurality of deposition modules are respectively arranged in a row in a left-right direction, and
one of the multi-turn transport devices of each of the two adjacent deposition modules is disposed to protrude forward compared to the other so that the substrate is transported in a straight line between the two adjacent deposition modules.

12. The apparatus of claim 10, wherein a guide roller transporting the substrate is disposed on both sides in left-right directions of each of the plurality of deposition modules, and
the substrate is configured to be transported between the two adjacent deposition modules through the guide roller.

13. The apparatus of claim 10, wherein each of the plurality of deposition modules includes a deposition device that deposits the buffer layer or the superconducting layer on the substrate, and a fixing plate on which the deposition device is fixedly mounted, and
the fixing plate is configured to be movable in an up-down direction.

14. A superconducting wire manufactured by the apparatus of claim 2, comprising:
a substrate;
an adhesive layer that is formed on the substrate;
a buffer layer that is formed on the adhesive layer; and
a superconducting layer that is formed on the buffer layer.

15. The superconducting wire of claim 14, wherein the adhesive layer is a Ni layer, a Cr layer, a Ti layer, or a NiCr layer, and
a thickness of the adhesive layer is 5 to 50 nm.
